# EUROPEAN PATENT SPECIFICATION

(11) **EP 1 366 207 B1**
(45) Date of publication and mention of the grant of the patent: **20.05.2009**
(21) Application number: 02705529.2
(22) Date of filing: 06.03.2002
(51) Int. Cl.: C23C 16/44

(54) **PLATING METHOD OF METAL FILM ON THE SURFACE OF POLYMER**
VERFAHREN ZUR ABSCHEIDUNG EINES METALLFILMS AUF DER OBERFLÄCHE EINES POLYMERS
PROCEDE DE PLACAGE DE COUCHE METALLIQUE SUR LA SURFACE D'UN POLYMERE

(30) Priority: 06.03.2001 KR 2001011334
(43) Date of publication of application: 03.12.2003
(73) Proprietor: Ryu, Seung-Kyun, Seoul 110-540 (KR)
(72) Inventor: RYU, Seung-Kyun;, Jong-No-Ku, Seoul 110-540 (KR); SU, Kon;, Su-Ku, Kwang-Ju 502-763 (KR)
(74) Representative: Prins, Adrianus Willem
(86) International application number: PCT/KR2002/000382
(87) International publication number: WO 2002/075020

(56) References cited:
- JP-A- 59 012 943
- JP-A- 63 247 376
- US-A- 4 731 156
- US-A- 5 527 566
- US-A- 5 696 207

## Description

### TECHNICAL FIELD

The present invention relates to a method for surface treatment and electroless plating conducted to fix a metal film to a polymeric material. More specifically, the present invention relates to a method, which comprises providing a hydrophilic functional group on the surface of a polymeric material with plasma treatment and then plating said surface with a metal film using electroless plating method.

### BACKGROUND ART

In comparison to the metal materials, the polymer materials have many advantages in that they are inexpensive and light, have good rigidity and processability, are chemically stable and have a good corrosion resistance, and therefore, have recently been used as an alternative material for metals in various fields of applications. Particularly, since the coating of the surface of polymer materials with metal films permits to add the functions of metals, the use of polymeric materials is remarkably broadened. Such materials have both the advantages of metals including hardness, better rigidity, electric conductivity, etc., and the advantages of polymer materials including lightness, processability, productivity, etc., and therefore, are very promising as the alternative material for metal processed articles such as brass, etc.

The methods for plating the polymer materials with the metal film for providing metallic properties such as conductivity, electricity shielding and brilliance to the polymer materials can be generally classified into two methods of wet plating and dry plating. Since the polymer materials are a non-conductor, the metal film cannot be deposited on the surface of polymer materials by an electroplating method.

The wet plating method permits to improve the adhesion of plating layers by treating the surface of polymers with an acid to generate the concavo-convex and forming the polar functional groups (see, Metal surface Compendium, Plastic Plating Techniques, page 13). However, the wet plating can be easily applied only to some polymer materials, such as ABS, of which the surface can be etched with acids, but has been very restrictively applied to the engineering polymer materials including polycarbonate, polyimide, teflon, etc.

Korean Laid-Open Patent Publication No. 1995-0027008 discloses the commercially available product produced by plating the through hole and the surface of a printed circuit board, which uses acrylonitrile/butadiene/styrene (ABS) resins and glass fiber reinforced epoxy resin, with a metal but does not teach the products prepared by plating with the metals the surface of polymer materials such as polyethylene, polypropylene, polycarbonate, polystyrene, Teflon, etc. as generally and, conventionally used in this field. The reason is that since the polymer materials are non-conductive and chemically very stable, it is very difficult to form the metal layer on the surface of polymer materials according to the generally used pre-treatment and electroless plating method.

US Patent Nos. 4941940 and 5049230 disclose that the electroless plating is conducted either after the polycarbonate is immersed into an organic solvent to swell the surface of the materials, and then subjected to fine roughening treatment, etched with an inorganic acid and allowed them to have a wettability with caustic bath, or after respective solutions are mixed together to form the first solution with which the polycarbonate is pre-treated.

British Patent No. 1124556 discloses the method which comprises polymerizing the surface of polymer materials containing styrene with a monomer to form a monovalent cationic group (nitride group), and then treating with an aqueous solution of acetone, etc., etching by immersion into the mixed acid of sulfuric acid and chromic acid, and then subjecting to electroless plating. Further, Japanese Laid-open Patent Publication No. 57-55933 discloses the electroless plating method which comprises subjecting the surface of polypropylene (PP) to roughening treatment in an alkaline solution containing sodium permanganate and sodium sulfite; and US Patent No. 4227963 discloses a method wherein the surface of polymer materials is etched using the mixture of sulfuric acid and carboxylic acid and then subjected to the electroless plating.

Recently, the polymer materials which can be plated according to the wet plating method using conductive filler remained after the high rigid materials are mixed with approximately several to few tens percent of etched ABS or inorganic fillers and then etched by treatment with an acid to form much concavo-convex portions have been produced (e.g. Japanese Laid-open Patent Publication Nos. Hei 8-269313, Hei 5-255582, Hei 8-199365 and Hei 6-333418 and Japanese Patent Publication No. Hei 2-36147). However, the addition of excessive inorganic fillers causes the lowering of properties of polymer materials and adhesion of the plated film, and induces an increase in the cost, which makes its commercialization difficult, and further, for improving the adhesion strength of the plated layer the concavo-convex portions should be remained to induce a deterioration of the appearance quality of the product. Furthermore, it also has the disadvantages that in comparison to the plating method wherein the electricity is passed through the aqueous solution, the adhesion strength itself is necessarily low since a gap present in the surface is filled with reduced metals, and further that since it requires an excessive deposition of metals, the metals and reducing agents should be used in a large amount, thereby waste water being largely produced to cause the environmental problem.

The dry plating method is a method for deposition of a metal on the surface of polymer material under vacuum and includes sputtering method, vapor deposition, vacuum deposition, etc. Since the dry plating does not require the reduction using electricity, the dry plating has many advantages in that it permits to plate the surface of non-conductive polymer materials, and further does not use the electrolyte solution so that wastewater is not produced and the plating thickness can be readily controlled. However, it has some disadvantages that adhesion, etching resistance and abrasion resistance of the plated film are inferior, the portions which are not directly exposed to evaporation source or target metals are not uniformly plated, and it is difficult to prepare the thick plated film. Furthermore, the dry plating method is only hardly applied to the other materials than a special product since the maintenance of a vacuum at an extremely high level in order to promote the evaporation of metals costs a great deal.

In order to make up for such disadvantages, the combined method of dry and wet plating processes has been proposed.

For example, US Patent No. 3801368 discloses the method for sputtering the surface of polymer materials to provide a doping of Au, Pt, etc. and then conducting the electroless plating; and Japanese Patent No. 92-240189 discloses the method for treating PTFE with UV laser in an amine or amide and then conducting the electroless plating. Further, US Patent No. 4354911 discloses the method for cleansing the surface of the materials with oxygen-argon gas plasma, thinly sputtering a catalyst metal, and then conducting the electroless plating. However, in practice, these methods have not been practically used.

European Patent No. 0268821 and US Patent No. US5340451 disclose the methods for making the surface of polymer materials hydrophilic with the gas plasma treatment and then practicing the electroless plating using Pd catalyst. This method may be readily available for practical purpose since its procedure is simple and uses the conventional electroless plating. However, it has the disadvantages in that the metal film formed on the polymer materials is not uniform and adhesion with the metal film and the reproducibility for metal film deposition are inferior.

Further, the prior coating methods for shielding electromagnetic wave of electronic equipments include three kinds of methods including 1) a vacuum metalizing wherein the metal is vaporized and deposited on the material surface under vacuum; 2) a conductive paint spray wherein the solution containing metal powder is sprayed onto the material surface; and 3) an electroless plating wherein the materials to be coated are placed in a plating bath and then plated using the reducing agent. At present, it has been known that most of Korean manufacturing companies generally use the conductive paint spray method and some of foreign companies including Nokia, etc. use the vacuum metalizing method using polymer alloy as the substrate.

Among those methods, the vacuum metalizing method has been generally used at the early stage of cellular phone production, but has scarcely used at present due to the problems that the productivity is low, because of low productivity, high cost and poor adhesion of metal film with substrate. Thus, in general, the conductive paint spray method and the electroless plating method have been currently used.

Currently many Korean companies use the conductive paints comprising silver or copper, which are mainly imported from America. Although this method can be applied to various materials regardless of thin surface properties and exhibits a good adhesion, it has some disadvantages that harmful material of the gaseous organic solvents may be discharged during drying step, and the cost is high.

On the contrary, the electroless plating method, which have been used in some foreign companies, uses a polymer alloy in which ABS resin is mixed as the filler so as to make the plating of high-rigid polycarbonate materials available. However, for such material, although ABS portion is dissolved with the acid so that the plating film can be readily formed, the physical properties including rigidity may be caused to be deteriorate, and further, it has many disadvantages including a generation of harmful materials, a lowering of the productivity, a difficulty in partial plating and a limitation on the materials to be applied. Although some Korean companies have developed the plating method for shielding electromagnetic wave of the polycarbonate (PC)-based materials, this method could not been practically utilized due to the problems in view of the procedures, including a low productivity and the problem in producing the non-plated area.

In addition, recently for the purpose of attaching the metal film to the polymer materials the method for plating the surface of polymer materials into which a hydrophilic functional groups are introduced, with the metal film by introducing said hydrophilic functional group into the surface of polymer materials using plasma and then conducting the electroless plating using a palladium/tin (Pd/Sn) catalyst has been reported (e.g. US Patent Nos. 4568562 and 4956197, EP 0 268 821A1, EP 0 478 975A2; US Patent Nos. 5696207 and 5340451). However, the result from plating according to the above-indicated patents is not so good and such a method has not been generally used for practical purpose.

Due to the above-mentioned problems, it is still required to develop a novel method for plating the polymer material with the metal film so that a composite material utilizing both of the advantage of stable and light polymer materials and the metallic materials having a metal conductivity can be used in various applications.

According to JP 59 012 943, a polyamide surface is treated by a low-temperature plasma, followed by electroless plating.

### DISCLOSURE OF THE INVENTION

In order to solve the above-mentioned problems, the present invention provides a method for plating a polymer material with a metal film, which can form the film on the surface of polymer materials, which are difficult to plate by the prior wet plating method, at a relatively low cost in comparison to the dry plating method and exhibits a uniform thickness and a good adhesion of the metal film and further, shows a good reproducibility.

Further, the present invention provides a product plated on the polymer materials for shielding electromagnetic wave according to said novel plating method.

To achieve the above-mentioned purposes, the present inventors have earnestly and extensively studied, and as a result, found that in the method for practicing the plating by introducing a hydrophilic functional group on the polymer materials and then conducting the electroless plating, the above-mentioned problems can be solved by lowering the contact angle of the surface of polymer materials to water by 5 to 60° in comparison to the untreated material according to the cold plasma treatment. Thus, we have completed the present invention.

The method of the present invention is defined by the features of claim 1 and comprises the first step of introducing the hydrophilic functional groups into the surface of polymer materials by a cold plasma treatment; and the second step of plating the surface of polymer materials into which said hydrophilic functional groups are introduced with a metal film, wherein the first step of introducing the hydrophilic functional group decreases the contact angle of the surface of polymer materials to water by 5 to 60° in comparison to the original material so that the hydrophilic functional group can be formed. Specifically, in order to plate the polymer materials with metal the polymer materials shall be treated with plasma to render the hydrophilicity to the surface of said material so that the particles of the novel metal compounds, such as Pd can be adsorbed onto the surface. However, excessive, plasma treatment may excessively increase the hydrophilicity of the surface to inhibit the electroless plating state. The reason is that water is strongly adsorbed onto the hydrophilic functional groups and thus, the approach of precursor of plated metal and reducing agent to the surface is strongly hindered. Even after plating, water is remained as a very thin layer between the polymer material and the plated layer, thereby causing a very easy detachment of the plated layer.

Further, it is preferred that the surface of the polymer material can be cleaned using an ultrasonic washing machine to improve the metal film plating, after the first step. In the prior art, it was reported that the polymers as the materials to be plated are cleaned with a cleansing agent or ultrasound before plasma treatment for rendering the hydrophilicity to the polymer materials, but the cleaning after plasma treatment has never been reported. The cleaning of the materials to be plated before plasma treatment is to remove any contamination present on the substrate and is totally different from the arrangement of hydrophilic functional groups by treatment with cleansing agent after plasma treatment, in view of the technical concepts. However, the mechanism to arrange the hydrophilic functional group as above has not been clearly established but is the subject, which can be sufficiently demonstrated in the future.

In the metal film plating method according to the present invention, it is preferred that the introduction of said hydrophilic functional groups is conducted by generating the cold plasma, although it may also be conducted by ionic radiation or the combination of ionic radiation and cold plasma treatment.

### BRIED DESCRIPTION OF DRAWINGS

Figure 1 is a scanning electron microphotograph, as enlarged by 100 times, of the surface of an electromagnetic wave shielding film prepared by spray painting of copper powder;
Figure 2 is a scanning electron microphotograph, as enlarged by 2000 times, of the surface of an electromagnetic wave shielding film prepared by spray painting of silver powder; and
Figure 3 is a scanning electron microphotograph, as enlarged by 2000 times, of an electromagnetic wave shielding film prepared according to the present invention.

### BEST MODE FOR CARRYING OUT THE INVENTION

In the plating method according to the present invention, when the cold plasma is used, the generation of cold plasma is preferably accomplished in a vacuum chamber maintained at a pressure of 100~5x10⁻⁴ Torr (1 Torr = 0,00133 bar) and a polymer temperature of 5 to 70°C. Further, it is preferred to generate the cold plasma using one or a mixture of two or more selected from the group consisting of low density air, acetone, acetaldehyde, formalin, acrylic acid, oxygen, nitrogen, argon and hydrogen.

When the cleaning is practiced after the step of introducing the hydrophilic functional groups by generation of said cold plasma according to the present invention, the cleaning is practiced either by immersion into an organic solvent for 0.1 to 5 minutes or by washing with an ultrasonic washing machine. As said organic solvent, a polar organic solvent is preferable and included, for example, methylene chloride, chloroform, dichloroethane, tetrachloroethane, trichloroethane, dimethylsulfoxide (DMSO), dimethylformamide (DMF), 1,4-dioxane, methanol, ethanol, propanol, isopropanol, sec-butylalcohol, etc. Among them, particularly tetrafluoroethylene or tetrachloroethylene are more preferable.

In the plating method according to the present invention, as the polymer materials to be applied one or a mixture of two or more selected from the group consisting of polyethylene, polypropylene, polystyrene, polycarbonate, acrylonitrile butadiene styrene (ABS), polyimide, acrylic resin, fluorine-based resin, epoxy resin and rubber can be used. As the novel metal catalyst which can be used, palladium is preferable. In addition, as the plating metal film copper film or nickel film can be preferably used.

The present invention also provides the method for providing the metal film plating which additionally comprises the re-plating step after said second step of plating the metal film. Said re-plating is preferably the wet plating method and is more preferable to plate the surface of polymer material with the metal layer incorporating the powder of magnetic material using the wet electroplating solution containing the powder of magnetic material.

After the second step of plating the metal film, the plating method according to the present invention may further comprise the additional step of heating the polymer material to a temperature below a softening point of the polymer material for 5 to 200 minutes. This heating step can improve the adhesion between said polymer material and the metal film layer.

In the plating method according to the present invention, for example, it is preferred that the first step includes the step of immersion into a solution containing palladium chloride (PdCl₂) 0.1~100 g/L, stannous chloride (SnCl₂) 0.1~100 g/L and hydrochloric acid (HCl) 50-400 g/L for one to 20 minutes and then washing with water and the second step is practiced by immersion into an aqueous solution containing 20-150 mL/L of sulfuric acid or hydrochloric acid at temperature of 15-40°C for one to 15 minutes, followed by the electroless plating.

In the plating method according to the present invention, the first step introduces the hydrophilic functional group to lower the contact angle with water, wherein the contact angle is preferably controlled so that it is lower than that of non-treated polymer material by 5 to 60°.

The method of the present invention further provides a plated product for shielding electromagnetic wave, which is obtained by plating the material to be plated according to the plating method of the present invention. In addition, the plating method according to the present invention can be included as a part of the process for producing a printed circuit board. In preparing the printed circuit board, the plating method according to the present invention can be used to plate after forming a hole by drilling procedure and also be used in forming the circuit, or in forming through holes, via holes or blind via holes.

The principle of the present invention is to prepare the film by generating the hydrophilic functional groups using either cold plasma containing reactive gas or ion injection and then deposition of the metal using the reducing agent under the condition wherein the metallic ion to be plated is concentrated on the surface of polar polymer material, without supplying any electricity.

The present invention particularly relates to a method for forming the metal film, which can be effectively used for shielding electromagnetic wave, by altering only the physical properties of the polar surface of the substrate with plasma, etc., and then forming the metal film on the surface of polymer material according to the electroless plating utilizing a novel metal catalyst such as palladium. The metal film plated according to the present invention is characterized by the fact that it has a tight film structure to provide a good ability of shielding electromagnetic wave and the productivity and economic of the plating method are superior, compared to other ones.

The polymer materials commonly referred to as a plastic are a material generally having hydrophobic property although it may be altered depending in the constitutional elements of monomers. Except for natural polymer materials having many hydroxyl groups such as cellulose, most of polyethylene (PE), polypropylene (PP), polystyrene (PS), polycarbonate (PC), fluorinated resin (Teflon, PTFE), epoxy resin, etc., which can be generally used in many goods for daily life and parts of machines are hydrophobic. Since such polymer materials are non-conductive, very stable and thus cannot be readily oxidized or reduced, their surface cannot be covered with the metal film by either the electroplating or the electroless plating as a chemical reducing method. However, if many functional groups capable of accumulating the metal ion are present on the surface of the polymer materials, the metal film can be formed according to the electroless plating using the reducing agents. This is the main idea from which the present invention is completed.

Although the treatment of polymer materials with an ion beam such as hydrogen in a reactive gas such as oxygen may induce the formation of functional groups on the surface of polymer materials, it should be considered that the cost involved in such treatment is great since this treatment shall be operated under high vacuum. Therefore, particularly when the cold plasma operated at low vacuum of approximately 10 Torr is utilized, the polar functional groups can be generated on the surface at a much low cost. When the materials such as acetone or acetic acid, which is capable of generating a polar groups on the surface by contained oxygen is activated with plasma and then reacted with polymer materials such as PE or PP, polar functional groups such as C=O or O-H are produced on the surface. The generation of polar functional groups can be directly identified either by measuring the contact angle of water on the surface of the treated polymer material or by observing to hydroxyl or carbonyl group by means of an infrared absorption spectrometer. Further, by controlling the treatment period and the operating conditions of plasma generating apparatus, the degree of generating functional groups can be controlled suitably for the kinds of metals to be plated and the desired thickness of the films.

In the electroless plating method, although the reducing agent can be heated for activation, it is difficult to heat the polymer materials and therefore, a catalyst is used. Although many kinds of catalysts can be used in this case, the working examples of the present invention utilize the suspension of Pd and Sn to fix palladium ion around polar functional groups on the surface. Palladium ion has the advantages that it can be readily reduced to the metallic state by reducing agent to provide the activated hydrogen, which is active for reducing the film-forming material such as copper. In order that the palladium ion can be well exposed, tin (Sn) added together with palladium is removed by washing with a weak acidic solution. Then, by adding the solution of the elements for forming the metal film, particularly the film of copper, nickel, etc. these metallic ions are concentrated onto the surface. Under such condition, by adding the reducing agent palladium ion is first reduced and then served as the catalyst to promote the reduction reaction of reducing agent. That is, the reducing agent is activated at the site of palladium ion fixed onto the surface of polymer materials and then reduces the metallic ion to deposit the metal onto the surface of polymer materials, thereby providing the tight metal film having a good adhesion property.

To tightly prepare the metal film and then strongly adhere the film to the surface of polymer materials, it is preferred that first, palladium catalyst shall be well fixed to the surface of polymer materials and, for such a purpose, the surface of polymer materials treated with cold plasma shall be washed with a suitable solvent to remove any interfering substances and contaminants including the surface plasma polymerization products generated during the plasma treatment procedures. Since the surface concentration of palladium ion is increased as many polar functional groups of the surface are exposed, and, after reduction, palladium ion can actively stimulate the reduction reaction on the surface of the metals, the metals can be readily reduced to form the tight metal film.

After the catalyst preparation is adhered closely to the surface of polymer material, the film-forming metal elements in the cationic state are added to the surface of polymer materials. Due to the presence of much anionic polar functional groups on the surface, the cationic metallic ion can be concentrated at the surface of polymer materials. When the reducing agent is added, it is activated at the surface of Pd catalyst to generate hydrogen atoms, which are added to the metallic ions to reduce to metal atoms, which are deposited onto the surface of the polymer materials as a metal film.

The procedure for deposition of the metals from the plating solution can be represented by the following reaction scheme for, for example, copper:

Cu²⁺ + 2HCHO + 40H⁻ →Cu + 2HCOO⁻ + 2H₂O + H₂ ↑ Cu²⁺ + HCHO + 30H- →Cu + HCOO⁻ + 2H₂O

The reaction for deposition of nickel can be illustrated as follow:

Ni²⁺ + H₂PO2⁻ + H₂O → Ni + H₂PO₃⁻ + 2H⁺

The metallic ions are reduced to the metal atoms by the above reaction and ultimately to form the plated metal film on the surface of polymer materials. Due to the formation of a closely adhered metal film layer on the surface of polymer materials the surface of polymer materials becomes to have an electric conductivity. When the metal film is formed on the surface of polymer material, it has a good conductivity. And so, copper and nickel may be additionally electrically plated to form a very thick layer of the metal film, thereby the smoothness of the surface being improved, and also the durability, electric conductivity and electromagnetic wave shielding being able to be enhanced.

Especially, in shielding the electromagnetic wave the additional copper plating can increase a shielding efficiency in the electric field, and the plating with nickel having a high rigidity as a magnetic body on the upper portion of copper film can be served as the shielding of magnetic filed and the protective layer for copper film.

For a plastic housing for cellular phone having a three-dimensional structure comprised of polycarbonate resin, by way of example, the gist of its manufacturing process can be illustrated as follows according to the process of the present invention:
(1) Step for inspection of the injection molded products and ultrasonic cleaning: The molded products are inspected with regard to poor appearance and then the contaminants including fingerprints, dust, organisms, etc. are examined. Then, the products are ultrasonically washed in ultrasonic cleaning equipment.
(2) Step of drying with hot air: The cleaning solution is removed from the surface of the substrate by hot air in the oven in order to remove reduction of the vacuum due to the presence of gas, in the subsequent step.
(3) Step of plasma treatment: The substrates are placed in the vacuum chamber and the surface of the substrate is treated by plasma to have hydrophilic functional groups enough to be capable of plating.
(4) Step of catalyst treatment: The substrates are immersed into the mixed solution of the catalyst rendering solution (e.g. PdCl₂) and stannous chloride (SnCl₂) for 5 minutes.
(5) Step of activation treatment: The substrates are subjected to activation treatment in 3-3.5% hydrochloric acid solution for 3 minutes and then washed three times with water.
(6) Step of electroless plating (in case of copper): The substrates are plated by immersing it into the electroless copper plating solution comprising the mixture of copper sulfate, formalin, caustic soda, EDTA, sodium bicarbonate, etc. for 20 minutes and then washed three times with water.
(7) Drying step: The substrates are washed with water in a warm bath at 65°C and then dried in a drying oven at 60°C.

The plated products obtained from the above procedures comprise a tight metal film of at least about 1 micron of copper.

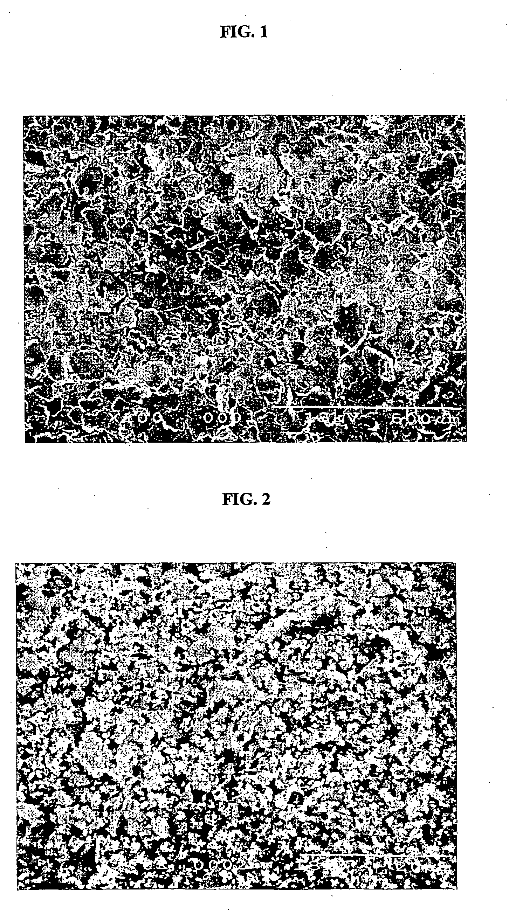

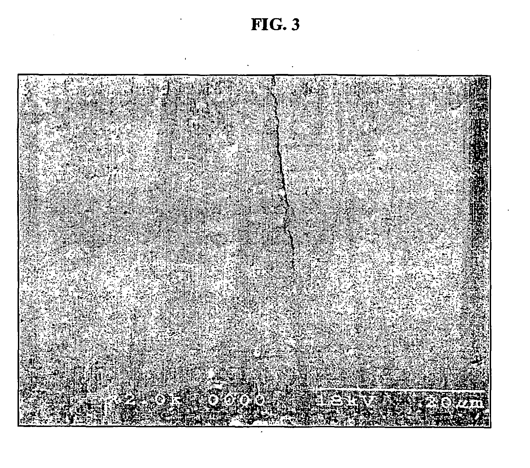

The figures appended to the specification illustrate the scanning electron microphotograph of the surface of an electromagnetic wave shielding film prepared by the method for shielding electromagnetic wave according to the present invention in comparison to the scanning electron microphotograph of the surface of an electromagnetic wave shielding film prepared by the prior spray plating method. First, Fig. 1 is the scanning electron microphotograph, as enlarged by 100 times, of the surface of an electromagnetic wave shielding film prepared by spray painting of copper powder as used in the prior art, wherein the particles coated on the surface of the coating layer are in the form of flake, coarse and large with having a size of about 50 µm, and are not tight. Fig. 2 is the photograph, as enlarged by 2000 times, of the surface of an electromagnetic wave shielding film prepared by spray painting of silver powder, which has generally been used at present, wherein the coating particles have a size of below 0.5 µm and are relatively fine and tight. Fig. 3 is the photograph, as enlarged by 2000 times, of an electromagnetic wave shielding film prepared according to the plating method of the present invention. In this photograph, it can be identified that since the plating particles are very fine and are tightly plated, no separated particles can be observed, and further that the uniformity of thickness is extremely good so that the concavo-convexes on the surface of the substrates disappear as they are.

In the present invention having the above-mentioned constitution, the polymer materials are treated with cold plasma or ion injection method to form the hydrophilic functional groups on the surface of polymer materials, which are stabilized with washing, and then the polymer materials are treated with cold plasma to form the hydrophilic functional groups on the surface, which are stabilized with washing, and Pd/Sn mixed catalyst preparation is then adsorbed thereon. Then, Sn is removed with the acid to expose Pd on the surface. Copper or nickel ions are concentrated around the polar functional groups present on the surface, and then they are reduced with the electroless reduction, which drives by activated reducing agents such as HCHO, etc., with Pd catalyst, to copper or nickel atom, thereby forming the metal film on the surface. Thus, the present invention provides the method for efficiently and inexpensively plating the surface of polymer materials with the metal film by effectively combing together the surface treatment with cold plasma, the surface stabilization, the electroless plating, etc., so that both of the limited matters involved in the wet plating method and the cost problem involved in the dry plating method can be settled.

Various properties and the properties related to electromagnetic wave shielding in case of the prior methods and the method according to the present invention are compared and shown in the following Table 1.

In the table, the shielding effect is the result obtained according to ASTM 4935-D Standard and in other items 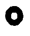 denotes superior good; ○ denotes good; Δ denotes normal; and X denotes inferior.

**Table 1**

| Coating technique | Method of the present invention | Vacuum metal deposition | Conductive metal deposition | | |
|---|---|---|---|---|---|
| | | | Nickel paint | Copper paint | Silver paint |
| Shielding effect (dB) | 80-110 | 60-60 | 40-60 | 50-70 | 70-80 |
| Conductivity at the contacted part | ○ | Δ | X | Δ | Δ |
| Uniformity of concavo-convex | 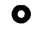 | X | Δ | Δ | Δ |
| Shielding effect /thickness | 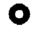 /2.5-3µ m | Δ /2 µ m | Δ /30~35 µm | Δ /30-35 µm | Δ /30-35 µ m |
| Thickness uniformity | 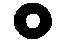 | Δ | Δ | Δ | Δ |
| Corrosion resistance and durability | 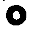 | ○ | ○ | Δ | Δ |
| Adhesion | ○ | X | ○ | ○ | ○ |

As compared in the above Table 1, it can be seen that the use of the method according to the present invention is superior over the use of other methods with respect to the properties shown in respective comparative items.

### EXAMPLES

The present invention is more specifically illustrated by the following examples. However, it should be understood that the present invention is not limited by these examples in any manner.

### Example 1 (Introduction of hydrophilic functional group)

The surface of PP polymer material was treated with cold plasma. The treatment conditions are as follows:
Treatment temperature: 15°C
Vacuum degree: 0.098 Torr
Treatment materials: acrylic acid, oxygen gas, methane gas
Treatment time: 3 minutes

Vaporized acrylic acid was exited with passing through a plasma generating apparatus to form the plasma state. Since some of them were strongly exited, they were either reacted together to form various molecules comprising carbon and oxygen or reacted with the surface of polymer materials to generate the polar functional groups on the surface. Therefore, the hydrophobic surface of polymer materials was converted into the hydrophilic state so that the contact angle can be greatly changed. From such change of the contact angle with water it could be determined whether or not the polar functional groups are generated on the surface of polymer materials.

The change of the contact angle with water due to enhancement of hydrophilicity of the polymer materials treated with acrylic acid plasma at low temperature is summarized in the following Table 2.

**Table 2**

| Change in the contact angle with water at the surface of the polymer materials treated with acrylic acid plasma | | |
|---|---|---|
| Polymer material | PP | PE |
| Before treatment | 90° | 93° |
| After treatment | 8.5° | 8.5° |

As shown in the above Table 2, in case of the treatment with acrylic acid plasma the contact angle of water at the surface of polymer materials was significantly lowered. This is the phenomenon caused by the formation of much hydrophilic functional groups on the surface of polymer materials to make the contact of water easy.

### Example 2 (Metal film plating by electroless plating)

The plasma-treated polymer material according to Example 1 was immersed into the plating bath solution containing Pd/Sn. The surface of polymer materials not treated with acrylic acid plasma was smooth and hydrophobic, and therefore, was not wet with Pd/Sn plating bath solution. Contrary to this, the surface of polymer materials treated with plasma are contained much polar functional group and therefore, was completely wet with the plating bath solution containing palladium, which acts as a catalyst in the procedures for electroless plating.

Then, the material was treated with the acid. At this time, tin was readily dissolved and removed whereas palladium was remained on the surface of the material and contributed to the activation of HCHO, which acts as the reducing agent in the electroless plating.

When the copper ion-containing solution is added to the palladium-deposited surface of polymer materials, copper ions are accumulated on the surface of polymer materials. Subsequently, when the reducing agent such as HCHO or HCOOH is added, copper atoms are deposited on the surface through self-catalytic reduction reaction. Palladium reduced by the reducing agent acts as the catalytically active phase, which activates the reducing agent required for copper reduction, to reduce copper ion accumulated on the surface of polymer materials to metallic copper.

The plasma-treated polymer material was plated according to the following procedures in order.

First step: The plasma-treated polymer material was immersed into tetrachloroethylene (TCE) solution at 21°C for one minute and then dried.

Second step: The substrate was immersed in the solution produced by mixing 100 mL/L of the plating bath solution containing 0.2 g/L of palladium chloride (PdCl₂) and 20 g/L of stannous chloride (SnCl₂), with 150 mL/L of hydrochloric acid, at 27-35°C for 5 minutes, and then washed three times with water.

Third step: The substrate was immersed in 100 mL/L of aqueous sulfuric acid (H₂SO₄) solution at 50°C for 5 minutes and then washed three times with water.

Fourth step: The substrate was immersed in the aqueous solution produced by mixing 7 g/L of copper sulfate (CuSO₄), 7 mL/L of formaldehyde (CH₂O) 5 g/L of caustic soda (NaOH) and 7 g/L of Rochelle salt, at 21°C for 5 minutes to conduct the electroless copper plating.

Fifth step: The polymer material plated from the above fourth step was washed with distilled water and then dried at 70°C for 100 minutes to increase the adhesion between the substrate and plated metal film.

### Change of the contact angle by introducing hydrophilic functional groups

In order to achieve the electroless plating on the polymer material, first Pd as the catalytically activated phase for the electroless plating should be stably and uniformly adsorbed and dispersed on the surface of polymer material so that the electroless plating can be uniformly preceded. If the surface of polymer material is hydrophobic, the surface is not wet with water and therefore, Pd and Sn dissolved in water cannot be dispersed onto the surface of polymer materials.

**Table 3**

| Change of the contact angle with water on the polymer materials by the plasma treatment (Unit: degree (°)) | | | | | | | | | |
|---|---|---|---|---|---|---|---|---|---|
| | PC | PVC | PET | PP | PS | PE | PTFE | Polyimide | Silicone rubber |
| Before treatment | 89 | 83 | 70 | 90 | 91 | 93 | 110 | 95 | 95 |
| After treatment | 56 | 46 | 45 | 51 | 65 | 81 | 95 | 68 | 70 |

Regardless of the kinds of polymer materials, the plasma treatment of their surface induces significantly an increase in hydrophilicity. Therefore, it could be identified that the plasma treatment can give the hydrophilicity to polymer materials.

### Comparison of the plating states according to the contact angle of the surface of polymer material

As previously stated, in order to plate the polymer material with the metal the polymer material should be treated with plasma to give the hydrophilicity to the surface so that Pd can be adsorbed onto the surface. However, when the plasma treatment is excessive, the electroless plating state is rather deteriorated. The reason is that water is first adsorbed to the hydrophilic functional groups to make the surface contact with copper ion or the reducing agent not so easy. Even after plating, water is remained as a very thin layer between the polymer material and the plated layer and therefore, the plated layer may be readily detached from the polymer material.

The surface having different hydrophilicity was subjected to the electroless plating with changing the degree of cold plasma treatment of PTFE surface. The result obtained therefrom is summarized in the following Table 4.

**Table 4**

| Influence of a difference in the contact angle of PTFE surface upon the plating state | | | |
|---|---|---|---|
| | Not treated with plasma | After plasma treatment | |
| Contact angle (°) | 110 | 95 | 33 |
| Plating coverage (%)* | 0 | 98 | 3 |

As can be seen from Table 7 shown below, if the hydrophilicity is excessively high, the plating is rather deteriorated. When the hydrophilicity is excessively potent, the surface of polymer material exhibits a high affinity to water rather than Pd as the catalyst for plating procedure or copper ion as the plating component, so that the plating is deteriorated. If the hydrophilic functional groups are much present, water formes the film on the surface of polymer material although it is very thin, and consequently the adhesion strength of the plated metal film is wakened.

### Comparison of the plating states by washing

The polypropylene surface treated with cold plasma was washed with tetrafluoroethylene for one minute and then compared with the surface, which was coated by the electroless plating but not washed. The result thus obtained is summarized in the following Table 5.

**Table 5**

| Comparison of the plating state of copper by washing | | |
|---|---|---|
| | Metal plating state | Plating coverage (%) |
| Not washed | poor | 34 |
| Washed with tetrafluoroethylene | good | 95 |

It could be seen that when the polymer material is treated with cold plasma, washed and then plated, the surface condition is stabilized and therefore, the plating state of the metal is significantly improved.

### Comparison of the plating coverage depending on heat treatment

Although the cold plasma-treated surface of polymer material can be coated by the electroless plating, the adhesion strength should be very important in order that it is used in industrial field. For such a purpose, the plated film can be suitably treated with heat to improve the bonding strength between the metal film as plated and the polymer material.

The adhesion state of the plated metal film on the surface of polymer material was evaluated according to the release test using adhesive tape, on the basis of ASTM D-3329-92a method. The release test evaluated the state of attachment of cooper film to the adhesive tape and the adhesion state derived from the amount (%) of metal remained on the surface after the release test, rather than the adhesion strength.

The transparent adhesive tape 3 cm long (width 10 mm) as produced by 3M Company was attached to the surface of the plated polymer material and then, detached by pulling it in a direction perpendicular to the material surface. Then, the state of the plated film remained on the surface of the material was examined. The plating coverage is defined as the fraction of the metal film remained on the surface after the release test, as expressed by percentage value.

The plated polymer material was heat-treated in a drying furnace at 60°C for one hour and then the degree of improvement in the plating state of the polymer material was compared as the plating coverage. The result thus obtained is shown in the following Table 6.

**Table 6**

| Improvement in the plating coverage due to heat treatment of the plated PE polymer material | | |
|---|---|---|
| | Non heat treatment | After heat treatment |
| Plating coverage (%) | 60 | 98 |

It could be seen that when the polymer material is suitably heat treated following the electroless plating, the adhesion strength between the polymer material and the plated film is significantly enhanced.

### Evaluation of the adhesion state of the plated metal film

The adhesion state of the metal film plated on the surface of polymer material was evaluated according to the release test using adhesive tape. The release test evaluated the state of attachment of copper film to the adhesive tape and the adhesion state derived from the amount (%) of metal remained on the surface after the release test, rather than the adhesion strength. The plating coverage thus obtained is shown in Table 7.

**Table 7**

| Plating coverage of the plated copper film on the polymer materials | | | | |
|---|---|---|---|---|
| Polymer material | PE | PP | PC | PTFE |
| In plasma treatment | | | | |
| Output (W) | 20 | 40 | 40 | 50 |
| Time (minute) | 10 | 5 | 5 | 5 |
| Reactive gas | oxygen | oxygen | low density air | Low density air |
| In electroless plating | | | | |
| Conc. of reducing agent (ml/L) | 7 | 7 | 7 | 7 |
| Time (minute) | 5 | 5 | 5 | 5 |
| Plating state | good | very good | extremely good | extremely good |
| Plating coverage (%) | 85 | 90 | 100 | 100 |

The surface of polymer material treated with plasma is in the very unstable state with disturbing the arrangement of surface elements, and further the organic mass is also attached to the surface. In such state, it is very difficult to expect that the metal would be satisfactorily attached to the surface of polymer material by the electroless plating. Therefore, by treating the cold plasma-treated surface of polymer material with the organic solvent to stabilize the surface condition and then plating the surface with the metal the plated film can be obtained in a very excellent adhesion state.

### INDUSTRIAL APPLICABILITY

As described above, the plating method according to the present invention can plate the surface of polymer material with the metal in the stable and easy manner and further, can endow new properties, which are not possessed by the polymer material itself, including improvement of appearance quality, improvement of mechanical properties, improvement of heat resistance and durability, decrease of absorptivity, rendering the conductivity and soldering ability, etc., to the polymer material. The polymer materials plated by the plating method according to the present invention improves their performance and therefore, can be used in various industrial field for shielding electromagnetic wave generated from the information processing related equipments, preparing the printed circuit board, preparing various forms of the electrodes and antistatic board, etc.

Further, according to the present invention various polymer materials can be plated with the metal film in an inexpensive, simple and convenient manner differently from the prior wet or dry plating method. In addition, by controlling the conditions of cold plasma treatment and the concentration of reducing agent the thickness of the plating metal film can be controlled in a broad range. Using cold plasma, oxygen-containing organic materials such as acetone, acrylate, ethylene, etc., low density air, water, inorganic gas such as oxygen, argon, etc. can be used to introduce the polar functional groups and selected suitably depending on the thickness, state and adhesion strength of the desired metal film. Moreover, since the cold plasma treatment and the electroless plating can be preceded with rotating or stirring the polymer materials, they can be applied to the materials having complex structures. The plating method according to the present invention can be effectively used particularly for coating the electromagnetic wave shielding film, provides a tight coating film in comparison to the prior methods, and can prepare the uniform electromagnetic wave shielding film regardless of the types of the materials to be coated, and further provides superior productivity and economic practicability.

## Claims

1. A method for plating the surface of polymer material with a metal film by treating the surface of polymer material with cold plasma method to introduce hydrophilic functional groups and then plating the surface of polymer material with a metal film according to the electroless plating method, wherein said method is **characterized in that** the cold plasma treatment reduces the contact angle of the surface of polymer materials to water by 5 to 60°, which method further comprises the step either of immersing the polymer material into an organic solvent for 0.1 to 5 minutes or of washing the polymer material with ultrasonic washing machine, after introducing the hydrophilic functional groups by the treatment of cold plasma.

2. The method according to claim 1, wherein the generation of cold, plasma is carried out in a vacuum chamber with maintaining the pressure of 100~5 x 10⁻⁴ Torr and the temperature of 5 to 70°C.

3. The method according to claim 2, wherein the organic solvent is a polar organic solvent.

4. The method according to claim 3, wherein the polar organic solvent is tetrafluoroethylene or tetrachloroethylene.

5. The method according to claim 1, wherein the generation of cold plasma is carried out by using one or a mixture of two or more selected from the group consisting of low density air, water, acetone, acetaldehyde, formalin, acrylic acid, oxygen, nitrogen, argon and hydrogen.

6. The method according to claim 1, wherein a catalyst is used in the electroless plating, and the catalyst is palladium, platinum, tin or a mixture thereof.

7. The method according to claim 1, wherein the polymer material is one or a mixture of two or more selected from the group consisting of polyethylene, polypropylene, polystyrene, polycarbonate, acrylonitrile butadiene styrene (ABS), polyimide, acrylic resin, fluorine-based resin, epoxy resin and rubber.

8. The method according to claim 1, wherein the metal film is nickel film or copper film, tin film or cobalt film, or a film of alloy thereof.

9. The method according to claim 1, which further comprises the step of carrying out a second plating after the surface of polymer material is plated with the metal film.

10. The method according to claim 9, wherein the second plating is carried out by a wet electrical plating method.

11. The method according to claim 10, wherein according to the wet plating method a metal layer into which a powder of magnetic material is incorporated is plated on the surface of polymer material, using a wet electroplating solution containing the powder of magnetic material.

12. The method according to claim 1, wherein after plating the surface of polymer material with the metal film, the polymer material is heated to the temperature below the softening point of the polymer material for 5 to 200 minutes.

13. The method according to claim 1, wherein the electroless plating is conducted after immersion into the solution containing 0.1~100 g/L of palladium chloride (PdCl₂) and 0.1~100 g/L of stannous chloride (SnCl₂) and 50~400 g/L of hydrochloric acid, at 15~50°C for 1 to 20 minutes.

14. The method according to claim 1, wherein the electroless plating is carried out after immersion into a solution containing 20-150 ml/ℓ of sulfuric acid or hydrochloric acid at 15 to 40°C for 1 to 15 minutes.

15. The method according to claim 9, wherein the plating solution during the procedure for forming the metal film by the wet plating method contains the powder of magnetic materials, and the conductive metal film layer formed by the wet plating method contains the powder of magnetic materials.

16. The method according to claim 15, wherein the powder of magnetic material contains permalloy or ferrite.

## Patentansprüche

1. Verfahren zum Plattieren der Oberfläche von Polymermaterial mit einem Metallfilm durch Behandeln der Oberfläche von Polymermaterial mit einem Kaltplasmaverfahren unter Einführung von hydrophilen funktionellen Gruppen und dann Plattieren der Oberfläche von Polymermaterial mit einem Metallfilm nach dem außenstromlosen Plattierverfahren, wobei das Verfahren **dadurch gekennzeichnet ist, dass** die Kaltplasmabehandlung den Kontaktwinkel der Oberfläche von Polymermaterialien mit Wasser um 5 bis 60° reduziert, wobei das Verfahren außerdem den Schritt eines Eintauchens des Polymermaterials in ein organisches Lösungsmittel für 0,1 bis 5 Minuten oder eines Waschens des Polymermaterials mit einer Ultraschallwaschmaschine nach Einführung der hydrophilen funktionellen Gruppen durch die Behandlung mit Kaltplasma umfasst.

2. Verfahren gemäß Anspruch 1, wobei die Erzeugung von Kaltplasma in einer Vakuumkammer unter Aufrechterhaltung des Drucks von 100-5 x 10⁻⁴ Torr und der Temperatur von 5 bis 70°C durchgeführt wird.

3. Verfahren gemäß Anspruch 2, wobei das organische Lösungsmittel ein polares organisches Lösungsmittel ist.

4. Verfahren gemäß Anspruch 3, wobei das polare organische Lösungsmittel Tetrafluorethylen oder Tetrachlorethylen ist.

5. Verfahren gemäß Anspruch 1, wobei die Erzeugung von Kaltplasma durch Verwendung eines oder eines Gemisches von zwei oder mehr, ausgewählt aus der Gruppe, bestehend aus Luft niedriger Dichte, Wasser, Aceton, Acetaldehyd, Formalin, Acrylsäure, Sauerstoff, Stickstoff, Argon und Wasserstoff, durchgeführt wird.

6. Verfahren gemäß Anspruch 1, wobei ein Katalysator bei dem außenstromlosen Plattieren verwendet wird und der Katalysator Palladium, Platin, Zinn oder ein Gemisch davon ist.

7. Verfahren gemäß Anspruch 1, wobei das Polymermaterial eines oder ein Gemisch von zwei oder mehr, ausgewählt aus der Gruppe, bestehend aus Polyethylen, Polypropylen, Polystyrol, Polycarbonat, Acrylnitril-Butadien-Styrol (ABS), Polyimid, Acrylharz, fluorbasiertem Harz, Epoxyharz und Kautschuk, ist.

8. Verfahren gemäß Anspruch 1, wobei der Metallfilm Nickelfilm oder Kupferfilm, Zinnfilm oder Kobaltfilm oder ein Film einer Legierung davon ist.

9. Verfahren gemäß Anspruch 1, das außerdem den Schritt eines zweiten Plattierens, nachdem die Oberfläche von Polymermaterial mit dem Metallfilm plattiert wurde, umfasst.

10. Verfahren gemäß Anspruch 9, wobei das zweite Plattieren durch ein elektrisches Nassplattierverfahren durchgeführt wird.

11. Verfahren gemäß Anspruch 10, wobei entsprechend dem Nassplattierverfahren eine Metallschicht, in welcher ein Pulver von magnetischem Material eingearbeitet ist, auf die Oberfläche von Polymermaterial plattiert wird, wobei eine Nasselektroplattierlösung, die das Pulver von magnetischem Material enthält, verwendet wird.

12. Verfahren gemäß Anspruch 1, wobei das Polymermaterial nach Plattieren der Oberfläche des Polymermaterials mit dem Metallfilm für 5 bis 200 Minuten auf die Temperatur unter dem Erweichungspunkt des Polymermaterials erwärmt wird.

13. Verfahren gemäß Anspruch 1, wobei das außenstromlose Plattieren nach Eintauchen in die Lösung, die 0,1-100 g/l Palladiumchlorid (PdCl₂) und 0,1-100 g/l Zinn(II)-chlorid (SnCl₂) und 50-400 g/l Salzsäure enthält, bei 15-50°C für 1 bis 20 Minuten durchgeführt wird.

14. Verfahren gemäß Anspruch 1, wobei das außenstromlose Plattieren nach Eintauchen in eine Lösung, die 20-150 ml/l Schwefelsäure oder Salzsäure enthält, bei 15 bis 40°C für 1 bis 15 Minuten durchgeführt wird.

15. Verfahren gemäß Anspruch 9, wobei die Plattierlösung während des Verfahrens zur Bildung des Metallfilms durch das Nassplattierverfahren das Pulver von magnetischen Materialien enthält und die leitende Metallfilmschicht, die durch das Nassplattierverfahren gebildet wird, das Pulver von magnetischen Materialien enthält.

16. Verfahren gemäß Anspruch 15, wobei das Pulver von magnetischem Material Permalloy oder Ferrit enthält.

## Revendications

1. Un procédé de placage de la surface d'un matériau polymère par un film métallique consistant à faire subir à la surface du matériau polymère un traitement par plasma froid pour introduire des groupes hydrophiles fonctionnels puis ensuite à revêtir la surface du matériau polymère d'un film métallique par déposition autocatalytique, procédé dans lequel ledit procédé est **caractérisé en ce que** le traitement par plasma froid réduit l'angle de contact de la surface des matériaux polymères par rapport à l'eau de 5 à 60°, ledit procédé comprenant en outre les étapes soit d'immersion du matériau polymère dans un solvant organique pendant 0,1 à 5 minutes, soit de lavage du matériau polymère dans une machine de lavage par ultrasons, après introduction des groupes hydrophiles fonctionnels par le traitement par le plasma froid.

2. Le procédé selon la revendication 1, dans lequel la génération du plasma froid est réalisée dans une chambre à vide dans laquelle la pression est maintenue à 100⁻⁵ x 10⁻⁴ Torr et la température est maintenue entre 5 et 70°C.

3. Le procédé selon la revendication 2, dans lequel le solvant organique est un solvant organique polaire.

4. Le procédé selon la revendication 3, dans lequel le solvant organique polaire consiste en tétrafluoroéthyléne ou tétracholoroéthyléne.

5. Le procédé selon la revendication 1, dans lequel la génération du plasma froid est réalisée par emploi de un ou plusieurs des composés du groupe comprenant l'air de faible densité, l'eau, l'acétone, l'acétaldéhyde, la formaline, l'acide acrylique, l'oxygène, l'azote, l'argon et l'hydrogène.

6. Le procédé selon la revendication 1, dans lequel un catalyseur est employé dans la déposition autocatalytique et en ce que le catalyseur consiste en palladium, platine, étain ou en un de leurs mélanges.

7. Le procédé selon la revendication 1, dans lequel le matériau polymère est formé de deux ou plusieurs des composés consistant en polyéthyléne, polypropyléne, polystyréne, polycarbonate, acrylonitrile-butadiene-styrene (ABS), polyimide, résine acrylique, résines fluorées, résine époxy et caoutchouc.

8. Le procédé selon la revendication 1, dans lequel le film métallique est un film de nickel ou de cuivre, un film d'étain ou de cobalt, ou un film formé de l'un de leurs alliages.

9. Le procédé selon la revendication 1, qui comprend en outre un second placage après que la surface du matériau polymère ait été revêtue par le film métallique.

10. Le procédé selon la revendication 9, dans lequel le deuxième placage est effectué par un procédé de déposition électrique.

11. Le procédé selon la revendication 10, dans lequel la surface du matériau polymère est revêtue par électrodéposition en phase humide d'une couche de métal dans laquelle une poudre de matière magnétique a été incorporée, dans lequel est employée une solution d'électrodéposition contenant la poudre de matière magnétique.

12. Le procédé selon la revendication 1, dans lequel, après placage de la surface du matériau polymère par le film métallique, le matériau polymère est chauffé à une température inférieure au point de ramollissement du matériau polymère durant 5 à 200 minutes.

13. Le procédé selon la revendication 1, dans lequel la déposition autocatalytique est réalisée après immersion dans la solution contenant 0,1 à 100 g/l de chlorure de palladium (PdCl₂) et 0,1 à 100 g/l de chlorure stanneux (SnCl₂) et 50 à 400 g/l d'acide chlorhydrique, à une température de 15 à 50°C pendant 1 à 20 minutes.

14. Le procédé selon la revendication 1, dans lequel la déposition autocatalytique est effectuée après immersion dans une solution contenant 20 à 150ml/l d'acide sulfurique ou d'acide chlorhydrique à 15 à 40°C pendant 1 à 15 minutes.

15. Le procédé selon la revendication 9, dans lequel la solution de placage durant le procédé de formation du film métallique par le procédé de déposition à l'état humide contient la poudre de matériaux magnétiques et la couche de film de métal conducteur formée par le procédé de déposition humide contient la poudre de matières magnétiques.

16. Le procédé selon la revendication 15, dans lequel la poudre de matières magnétiques contient permalloy ou ferrite.
